# EUROPEAN PATENT APPLICATION

(11) **EP 4 183 840 A1**
(43) Date of publication of application: **24.05.2023**
(21) Application number: 21821377.5
(22) Date of filing: 20.05.2021
(51) Int. Cl.: C09D 4/02, C09D 7/63, C09D 5/08, B05D 1/00, B05D 7/24, C09D 135/02, C09D 133/08, C09D 133/10

(54) **PROTECTIVE COATING AND PREPARATION METHOD THEREOF**

(30) Priority: 09.06.2020 CN 202010526322; 09.06.2020 CN 202010526684
(71) Applicant: Jiangsu Favored Nanotechnology Co., Ltd., Wuxi, Jiangsu 214000 (CN)
(72) Inventor: ZONG, Jian, Wuxi, Jiangsu 214000 (CN)
(74) Representative: Mewburn Ellis LLP
(86) International application number: PCT/CN2021/094737
(87) International publication number: WO 2021/249145

(57) **Abstract**

The specific embodiment of the present disclosure provides a protective coating. An anticorrosive coating having a compact rigid molecular structure is formed by plasma polymerization coating of monomers including alicyclic epoxy structural units, and a hydrophobic coating is simultaneously formed by plasma polymerization coating on the anticorrosive coating, thus, coatings with excellent protective performance to the substrate are formed.

## Description

### CROSS-REFERENCE TO RELATED APPLICATIONS

This application claims the priority to Chinese Application No. 202010526322.5, filed on June 9th, 2020, and entitled "PROTECTIVE COATING AND PREPARATION METHOD THEREOF", and to Chinese Application No. 202010526684.4, filed on June 9th, 2020, and entitled "PROTECTIVE COATING AND PREPARATION METHOD THEREOF", the contents of which are incorporated herein by reference in their entirety.

### TECHNICAL FIELD

The present disclosure relates to the field of plasma chemistry, and more particularly, to a plasma polymerization protective coating and a preparation method thereof.

### BACKGROUND

An organic polymer coating can effectively protect a surface of different materials. Among methods for preparing organic polymer coatings, the vapor deposition method is a mainstream method for preparing polymer protective coatings on a surface of a substrate, which is economical practical and easy to operate. In particular, the plasma chemical vapor deposition uses plasma to activate reaction monomer gas to deposit on a surface of a substrate, which is applicable for various substrates. In addition, the deposited polymer protective coating is uniform, the coating preparation temperature is low, the coating thickness is thin, the stress is small, and it hardly has damage to the substrate surface as well as less effect on the substrate performance.

For plasma polymerization coatings, selection of plasma polymerization monomers has always been one of the important research topics. For example, organosiloxane can be used as a monomer to prepare a plasma polymerization coating, and a mixture of monofunctional unsaturated fluorocarbon resin and polyfunctional unsaturated hydrocarbon derivative can be used as monomer for plasma polymerization coating, which may result in a coating with a dense network structure that can protect metal and the like.

### SUMMARY

The specific embodiment of the present disclosure provides a new type of protective coating formed by plasma polymerization of monomer and a preparation method thereof, as illustrated in the following:

A protective coating II, which is a plasma polymerization coating formed on a surface of a substrate by contacting plasmas, wherein the plasmas include a plasma of a monomer α, and the monomer α includes an alicyclic epoxy structural unit shown in formula (1), 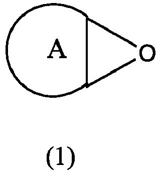 wherein, A is a three to twenty-membered alicyclic structure.

Optionally, the A is a five-membered alicyclic structure or a six-membered alicyclic structure.

Optionally, the monomer α further includes at least one selected from a group consisting of: a carbon-carbon double bond structural unit, a carbon-carbon triple bond structural unit, and an epoxy structural unit.

Optionally, the monomer α has a structure shown in formula (2), 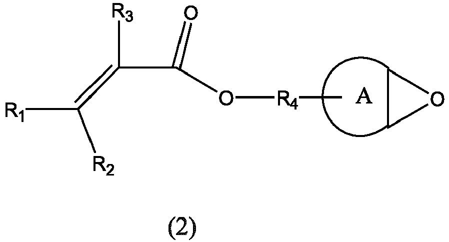
wherein, R₁, R₂ and R₃ are respectively and independently selected from a group consisting of: a hydrogen atom, a C₁-C₁₀ alkyl, and a halogen-substituted C₁-C₁₀ alkyl;
and R₄ is a connecting bond, a C₁-C₁₀ alkylene or a halogen-substituted C₁-C₁₀ alkylene.

Optionally, the R₁, the R₂ and the R₃ are respectively and independently selected from a group consisting of a hydrogen atom and a methyl; and R₄ is a connecting bond, a methylene or an ethylidene.

Optionally, the monomer α has a structure shown in formula (3) or a structure shown in formula (4).

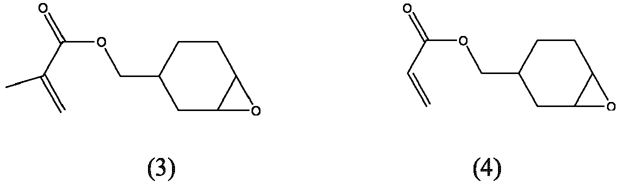

Optionally, the monomer α has a structure shown in formula (5), 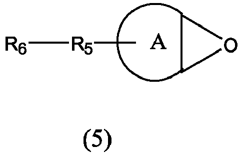 wherein, R₅ is a connecting bond, a C₁-C₁₀ alkylene or a halogen-substituted C₁-C₁₀ alkylene, and R₆ has a structure selected from a group consisting of: 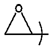 or 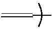 .

Optionally, the monomer α has a structure shown in formula (6) or a structure shown in formula (7).

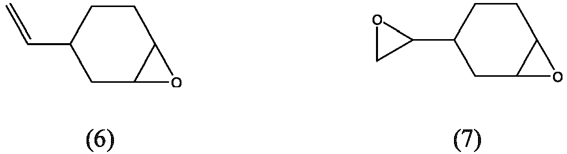

Optionally, the monomer α has a structure shown in formula (8), 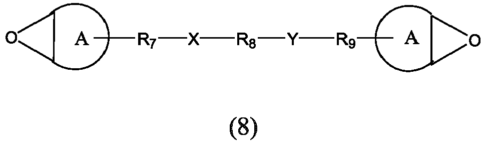
wherein, R₇ and R₉ are respectively and independently selected from a group consisting of: a connecting bond, a C₁-C₁₀ alkylene, and a halogen-substituted C₁-C₁₀ alkylene;
R₈ is a C₁-C₁₀ alkylene or a halogen-substituted C₁-C₁₀ alkylene;
and X and Y are respectively and independently selected from a group consisting of: a connecting bond, an oxygen atom, a carbonyl, and an ester.

Optionally, the monomer α has a structure shown in formula (9) or a structure shown in formula (10).

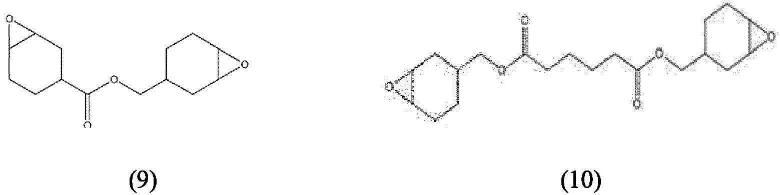

Optionally, the plasmas also include a plasma of a monomer β, the monomer β includes a structural unit a;
and the structural unit a has a structure shown in formula (11); 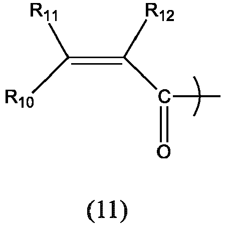
wherein, R₁₀, R₁₁ and R₁₂ are respectively and independently selected from a group consisting of: a hydrogen atom, a C₁-C₁₀ alkyl, and a halogen-substituted C₁-C₁₀ alkyl.

Optionally, the monomer β also includes a structural unit b, and the structural unit b includes at least one selected from a group consisting of: a double bond structural unit, a triple bond structural unit, and an epoxy structural unit.

Optionally, the structural unit b has a structure shown in formula (12), 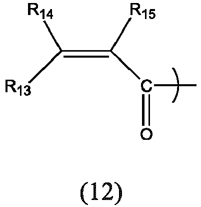 wherein, R₁₃, R₁₄ and R₁₅ are respectively and independently selected from a group consisting of: a hydrogen atom, a C₁-C₁₀ alkyl, and a halogen-substituted C₁-C₁₀ alkyl.

Optionally, the monomer β has a structure shown in formula (13), 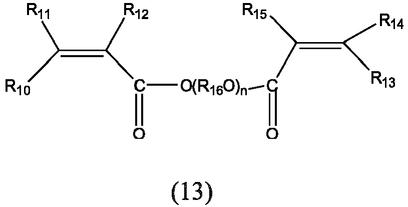 wherein, R₁₆ is a C₂-C₁₀ alkylene or a halogen-substituted C₂-C₁₀ alkylene, and n is an integer ranging from 1 to 10.

Optionally, the R₁₀, R₁₁, R₁₂, R₁₃, R₁₄ and R₁₅ are respectively and independently selected from a group consisting of a hydrogen atom and a methyl.

Optionally, the substrate is selected from metal, plastic, fabric, glass, electrical assemblies, optical instruments or electrical components.

A preparation method of the aforementioned protective coating includes:
providing a substrate;
and contacting the substrate with plasmas to form a plasma polymerization coating on a surface of the substrate.

Optionally, the plasmas are excited in a pulse manner.

Optionally, a pulse frequency of the pulse manner ranges from 20Hz to 80kHz, a pulse duty cycle ranges from 0.1% to 80%, and an average pulse power density ranges from 0.001W/m³ to 500W/m³.

A device includes any of the aforementioned protective coating on at least part of the surface thereof.

A protective coating includes a coating I and a coating II deposited on a substrate,
and the coating II is any of the aforementioned protective coating II;
the coating I is a plasma polymerization coating formed on the coating II by contacting the coating II with a plasma including a monomer γ;
and the monomer γ includes one or more selected from a group consisting of an alkane, a halogenated alkane, an alkene, a halogenated alkene, an alkyne, a halogenated alkyne, an acrylic ester, and a halogenated acrylic ester.

Optionally, the monomer γ has a structure shown in formula (14), 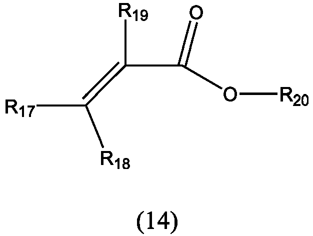
wherein, R₁₇, R₁₈ and R₁₉ are respectively and independently selected from a group consisting of: a hydrogen atom, a C₁-C₁₀ alkyl, and a halogen-substituted C₁-C₁₀ alkyl;
and R₂₀ is a C₁-C₂₀ hydrocarbyl or a halogen-substituted C₁-C₂₀ hydrocarbyl.

Optionally, the R₁₇, R₁₈ and R₁₉ are respectively and independently selected from a group consisting of a hydrogen atom and a methyl; and R₂₀ is a C₄-C₂₀ hydrocarbyl or a halogen-substituted C₄-C₂₀ hydrocarbyl.

Optionally, the monomer γ has a structure shown in formula (15), 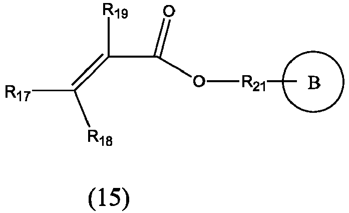
wherein, R₂₁ is a connecting bond, a C₁-C₁₀ alkylene, and a halogen-substituted C₁-C₁₀ alkylene;
and B is an aromatic ring structure or a three to twenty-membered alicyclic structure.

Optionally, the R₂₁ is a connecting bond, a methylene or an ethylidene, and B is a cyclohexyl or a cyclopentyl.

Optionally, the protective coating further includes a coating III, and the coating III is a plasma polymerization coating formed by contacting the substrate with a plasma including a monomer δ;
the coating II is a plasma polymerization coating formed on the coating III by contacting the coating III with a plasma including a monomer δ;
and the monomer δ includes a structural unit c and a structural unit d, and the structural unit c and the structural unit d both have a carbon-carbon double bond structure and an ester structure respectively.

Optionally, the structural unit c has a structure shown in formula (16), 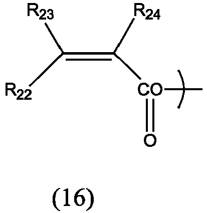 wherein, R₂₂, R₂₃ and R₂₄ are respectively and independently selected from a group consisting of: a hydrogen atom, a C₁-C₁₀ alkyl, and a halogen-substituted C₁-C₁₀ alkyl.

Optionally, the structural unit d has a structure shown in formula (17), 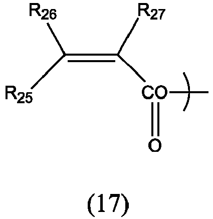 wherein, R₂₅, R₂₆ and R₂₇ are respectively and independently selected from a group consisting of: a hydrogen atom, a C₁-C₁₀ alkyl, and a halogen-substituted C₁-C₁₀ alkyl.

Optionally, the monomer δ has a structure shown in formula (18), 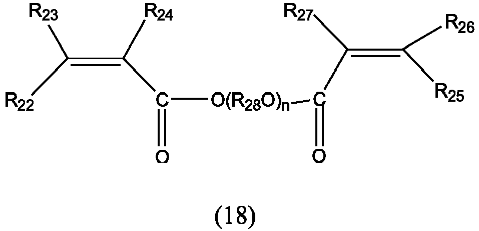 wherein, R₂₈ is a C₂-C₁₀ alkylene or a halogen-substituted C₂-C₁₀ alkylene, n is an integer ranging from 0 to 10, wherein R₂₂, R₂₃, R₂₄, R₂₅, R₂₆ and R₂₇ are respectively and independently selected from a group consisting of a hydrogen atom, a C₁-C₁₀ alkyl, and a halogen-substituted C₁-C₁₀ alkyl.

Optionally, the R₂₂, R₂₃, R₂₄, R₂₅, R₂₆ and R₂₇ are respectively and independently selected from a group consisting of a hydrogen atom and a methyl.

A preparation method of any of the aforementioned protective coating includes:
providing a substrate;
and forming the protective coating on the substrate by performing a plasma deposition.

Optionally, the plasma is a pulse plasma.

Optionally, the pulse plasma is generated by applying a pulse voltage discharge, wherein, a pulse power ranges from 20W to 500W, a pulse frequency ranges from 20Hz to 80kHz, a pulse duty cycle ranges from 0.1% to 80%, and a plasma discharge duration time ranges from 100s to 20000s.

A device includes any of the aforementioned protective coating on at least part of the surface thereof.

According to a specific embodiment of the present disclosure, the protective coating II is formed by plasma polymerization coating of monomers including alicyclic epoxy structural units, which is provided with a compact rigid molecular structure and a protective performance of which is improved. Further, the monomers including the alicyclic epoxy structural units have a multi-functional group site for combination, especially a multi-functional group monomer including an acrylate structure. A monomer including alicyclic epoxy structural unit can form a plurality of active sites to cross-link under plasma discharge to form a dense network structure, which has a high binding force with a substrate, especially metal, and can improve a corrosion resistance of the metal.

According to a specific embodiment of the present disclosure, an anticorrosive coating having a compact rigid molecular structure is formed by plasma polymerization coating of monomers including alicyclic epoxy structural units, and a hydrophobic coating is simultaneously formed by plasma polymerization coating on the anticorrosive coating, thus, coatings with excellent protective performance to the substrate are formed. Further, when a plasma monomer of the hydrophobic coating uses a monomer including alicyclic epoxy structural unit, the hydrophobic coating has a strong adhesion to the anti-corrosion coating, resulting in a better protective performance.

### DETAILED DESCRIPTION

According to some specific embodiments of the present disclosure, a protective coating II is a plasma polymerization coating formed on a surface of a substrate when the substrate contacts plasmas, and the plasmas include a plasma of a monomer α, and the monomer α includes an alicyclic epoxy structural unit shown in formula (1), 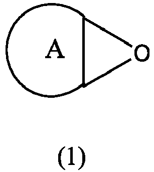 wherein, A is a three to twenty-membered alicyclic structure.

According to some specific embodiments of the present disclosure, the alicyclic structure includes one or more substituents which may include alkyl such as methyl, ethyl, propyl, butyl, etc. The substituents may include halogen atom such as fluorine, chlorine, etc. The substituents may also include halogen-substituted alkyl such as fluorine-substituted methyl, chlorine-substituted methyl, fluorine-substituted ethyl, chlorine-substituted ethyl, fluorine-substituted propyl, chlorine-substituted propyl, fluorine-substituted butyl, chlorine-substituted butyl, etc.

According to some specific embodiments of the present disclosure, the A is a five-membered alicyclic structure or a six-membered alicyclic structure, which is rigid and stable.

According to some specific embodiments of the present disclosure, the monomer α further includes at least one selected from a group consisting of: a carbon-carbon double bond structural unit, a carbon-carbon triple bond structural unit, and an epoxy structural unit, which is conducive to forming a dense network structure by cross-linking multiple active sites. For example, the monomer α may be one or more selected from a group consisting of a 3,4-epoxycyclohexylmethyl-3,4-epoxycyclohexyl formate, a 3,4-epoxycyclohexylmethyl methacrylate, a 3,4-epoxy cyclohexyl methacrylate, a 1,2-epoxy-4-vinyl cyclohexane, a bis (2,3-epoxycyclopentyl) ether, a 2,3-epoxycyclopentyl cyclopentyl ether, a vinyl cyclohexene diepoxide, a di-isoprene diepoxide, a bis ((3,4-epoxycyclohexyl) methyl) adipate, a 3,4-epoxy-6-methylcyclohexyl carboxylic acid - 3', 4' - epoxy-6'-methylcyclohexyl methyl ester, a dicyclopentadiene diepoxide, and the like. According to some specific embodiments of the present disclosure, the monomer α has a structure shown in formula (2), 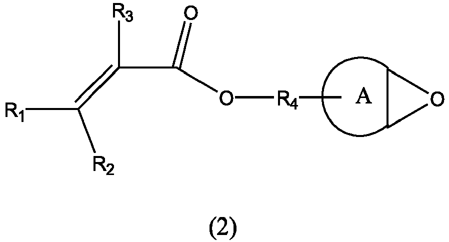 wherein, R₁, R₂ and R₃ are respectively and independently selected from a group consisting of: a hydrogen atom, a C₁-C₁₀ alkyl, and a halogen-substituted C₁-C₁₀ alkyl, and R₄ is a connecting bond, a C₁-C₁₀ alkylene or a halogen-substituted C₁-C₁₀ alkylene. Further, the R₁, R₂ and R₃ are respectively and independently selected from a group consisting of a hydrogen atom, a C₁-C₄ alkyl, and a halogen-substituted C₁-C₁₀ alkyl, and the R₄ is a connecting bond, a C₁-C₄ alkylene or a halogen-substituted C₁-C₁₀ alkylene. Further, the R₁, R₂ and R₃ are respectively and independently selected from a group consisting of a hydrogen atom and a methyl, and the R₄ is a connecting bond, a methylene or an ethylidene. For example, the monomer α can be a 3,4-epoxycyclohexylmethyl methacrylate having a structure shown in formula (3), or can be a 3,4-epoxy cyclohexyl methacrylate having a structure shown in formula (4).

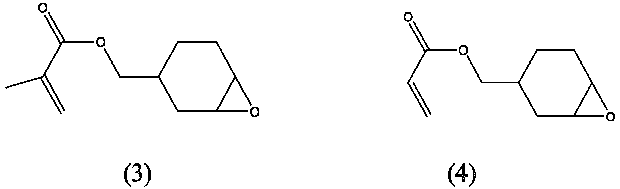

According to some specific embodiments of the present disclosure, the monomer α has a structure shown in formula (5), 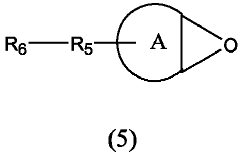 wherein, R₅ is a connecting bond, a C₁-C₁₀ alkylene or a halogen-substituted C₁-C₁₀ alkylene, and R₆ has a structure selected from a group consisting of 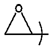 or 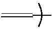 . Further, R₅ is a connecting bond, a C₁-C₄ alkylene or a halogen-substituted C₁-C₄ alkylene. For example, the monomer α can be a 1,2-epoxy-4-vinyl cyclohexane having a structure shown in formula (6), or can be a vinyl cyclohexene diepoxide having a structure shown in formula (7).

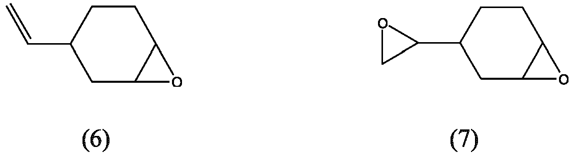

According to some specific embodiments of the present disclosure, the monomer α has a structure shown in formula (8), 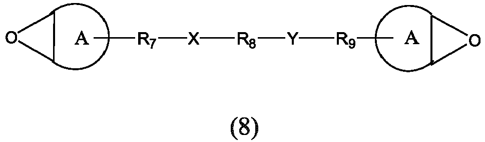 wherein, R₇ and R₉ are respectively and independently selected from a group consisting of: a connecting bond, a C₁-C₁₀ alkylene, and a halogen-substituted C₁-C₁₀ alkylene. Further, R₇ and R₉ are respectively and independently selected from a group consisting of: a connecting bond, a C₁-C₄ alkylene, and a halogen-substituted C₁-C₄ alkylene. X and Y are respectively and independently selected from a group consisting of: a connecting bond, an oxygen atom, a carbonyl, and an ester. For example, the monomer α can be a 3,4-epoxycyclohexylmethyl-3,4-epoxycyclohexyl formate having a structure shown in formula (9), or can be a bis ((3,4-epoxycyclohexyl) methyl) adipate having a structure shown in formula (10).

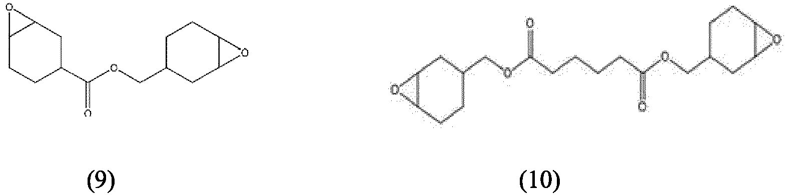

According to some specific embodiments of the present disclosure, the plasmas only include a plasma of the monomer α. According to some specific embodiments of the present disclosure, in order to form a dense protective coating having a strong adhesion to the substrate, the plasmas include a plasma of the monomer α and a plasma of a monomer β, the monomer β includes a structural unit a, and the structural unit a has a structure shown in formula (11), 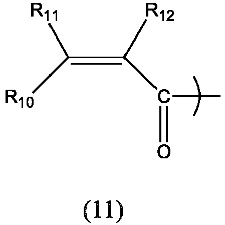 wherein, R₁₀, R₁₁ and R₁₂ are respectively and independently selected from a group consisting of: a hydrogen atom, a C₁-C₁₀ alkyl, and a halogen-substituted C₁-C₁₀ alkyl. For example, the monomer β may be one or more selected from a group consisting of: a acrylic acid, a hydroxyethyl acrylate, a hydroxypropyl acrylate, a methacrylic acid, a hydroxyethyl methacrylate, a hydroxypropyl methacrylate, a butyl acrylate, a 1,4-butanediol methacrylate, a 1,6-hexanediol diacrylate, a 1,6-hexanediol dimethacrylate, a ethylene glycol dimethacrylate, a diethylene glycol dimethacrylate, a triethylene glycol dimethacrylate, a tetraethylene glycol dimethacrylate, a 1,3-butanediol dimethacrylate, a neopentyl glycol dimethacrylate and the like. Further, the R₁₀, R₁₁ and R₁₂ are respectively and independently selected from a group consisting of: a hydrogen atom, a C₁-C₄ alkyl, and a halogen-substituted C₁-C₄ alkyl. Further, the R₁₀, R₁₁ and R₁₂ are respectively and independently selected from a group consisting of: a hydrogen atom and a methyl. Further, the monomer β also includes a structural unit b, and the structural unit b includes at least one selected from a group consisting of: a double bond structural unit, a triple bond structural unit, and an epoxy structural unit. Further, the structural unit b has a structure shown in formula (12), 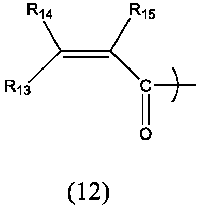 wherein, R₁₃, R₁₄ and R₁₅ are respectively and independently selected from a group consisting of: a hydrogen atom, a C₁-C₁₀ alkyl, and a halogen-substituted C₁-C₁₀ alkyl. Further, the R₁₃, R₁₄ and R₁₅ are respectively and independently selected from a group consisting of a hydrogen atom, a C₁-C₄ alkyl, and a halogen-substituted C₁-C₄ alkyl. Further, the R₁₃, R₁₄ and R₁₅ are respectively and independently selected from a group consisting of a hydrogen atom and a methyl. Further, the monomer β has a structure shown in formula (13), 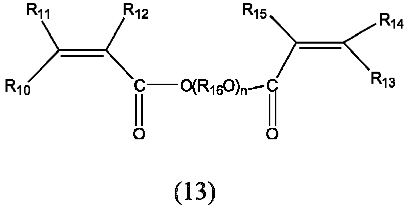 wherein, R₁₆ is a C₂-C₁₀ alkylene or a halogen-substituted C₂-C₁₀ alkylene, and n is an integer ranging from 1 to 10. For example, n is an integer of 1, R₁₁ is a C₂-C₁₀ alkylene such as an ethylidene, a propylidene, a butylidene, a pentylidene, etc. For example, n is an integer of 1, R₁₁ is a halogen-substituted C₂-C₁₀ alkylene such as a halogen-substituted ethylidene, a halogen-substituted propylidene, a halogen-substituted butylidene, a halogen-substituted pentylidene, etc. For example, n is an integer ranging from 2 to 10, R₁₁ is an ethylidene or a propylidene. According to some specific embodiments of the present disclosure, bonding the monomer α including an alicyclic epoxy structural unit with the monomer β including an acrylate structure, especially with the monomer β including a diacrylate structure shown in formula (13), it is more conducive to forming a dense protective coating with strong adhesion force with the substrate after the plasma coating, and a corrosion resistance of the substrate is further improved.

According to some specific embodiments of the present disclosure, an addition amount of the monomer β and an addition amount of the monomer α can be adjusted according to the actual situation. Generally, a mass ratio of the monomer β to the monomer α ranges from 1:10 to 10:1, such as 1:1, 1:2, 1:3, 2:3, 1:4, 1:5, 2:1, 3:1, 3:2,4:1, 5:1, etc.

According to some specific embodiments of the present disclosure, the substrate is a metal, such as iron, magnesium, aluminum, copper or an alloy thereof. According to some specific embodiments, the substrate is plastic, fabric, glass, electrical assemblies, or optical instruments. Specifically, the electrical assemblies can be printed circuit boards (PCB), electronic products or electronic assembly semifinished products. The substrate can be an electronic product, for example, it is not limited to a mobile phone, a tablet, a keyboard, an e-reader, a wearable, a display, etc. The substrate can also be any suitable electrical component of the electrical assemblies. Specifically, the electrical component can be a resistor, capacitor, transistor, diode, amplifier, relay, transformer, battery, fuse, integrated circuit, switch, LED, LED display, piezoelectric element, optoelectronic component or antenna or oscillator.

According to some specific embodiments of the present disclosure, a preparation method of the aforementioned protective coating II is provided. The preparation method includes: providing a substrate, and contacting the substrate with plasmas to form a plasma polymerization coating on a surface of the substrate. The plasmas and the substrate are described as above.

According to some specific embodiments of the present disclosure, for further enhancing an adhesion between the plasma coating and the substrate, the substrate for coating is pretreated by continuous plasma. For example, in an inert gas atmosphere, a plasma discharge power ranges from 20W to 500W, a discharge mode is continuous, and a duration time of discharge ranges from 1min to 15min. According to some specific embodiments, the substrate for coating is pretreated by means of heat, oxygen or high-energy radiation.

According to some specific embodiments of the present disclosure, the plasmas are excited by a continuous wave. According to some specific embodiments, the plasmas are excited in a pulse manner. The specific conditions of plasma coating can adopt the corresponding conditions in conventional technology. For example, the substrate is placed in a reaction chamber of a plasma chamber, the reaction chamber is vacuumized to 20mTorr to 250mTorr, and inert gases such as He, Ar, O₂ or mixed gases thereof are introduced. A monomer for reacting is introduced into the chamber in the form of vapor, and the flow rate of the monomer ranges from 10µL/min to 2000µL/min. The power supply is turned on to generate plasma, so that a chemical vapor deposition occurs on the surface of the substrate. The temperature in the chamber is controlled in a range of 20°C to 80°C, the monomer is gasified at a temperature ranging from 50°C to 120°C and under vacuum condition. The plasmas are excited in a continuous wave, a plasma discharge power ranges from 10W to 180W, and a discharge duration time ranges from 10min to 600min. Alternatively, the plasmas can be excited in a pulse mode, a pulse frequency in the pulse mode ranges from 20Hz to 80KHz, a duty cycle ranges from 0.1% to 80%, and an average pulse power density ranges from 0.001W/m³ to 500W/m³.

According to some specific embodiments of the present disclosure, the plasma discharge methods can be various conventional discharge methods, for example, electrodeless discharge (e.g. radio frequency inductively coupled discharge, microwave discharge), single-electrode discharge (e.g. corona discharge, plasma jet formed by single-electrode discharge), two-electrode discharge (e.g. dielectric barrier discharge, exposed electrode radio frequency glow discharge) and multi-electrode discharge (e.g. discharge using a floating electrode as the third electrode).

A device is also provided by some specific embodiments of the present disclosure. At least part of the surface of the device has any of the aforementioned protective coating II. According to some specific embodiments, only the aforementioned protective coating II is formed on part of or all of the surface of the device. According to some specific embodiments, the aforementioned protective coating II and other coating are formed on part of or all of the surface of the device.

A protective coating is also provided by some specific embodiments of the present disclosure, which includes a coating I and a coating II deposited on a substrate;
the coating II is the aforementioned protective coating II;
the coating I is a plasma polymerization coating formed on the coating II by contacting the coating II with a plasma including a monomer γ;
and the monomer γ includes one or more selected from a group consisting of an alkane, a halogenated alkane, an alkene, a halogenated alkene, an alkyne, a halogenated alkyne, an acrylic ester, and a halogenated acrylic ester.

According to some specific embodiments of the present disclosure, the coating I is a plasma polymerization coating formed on the coating II by contacting the coating II with a plasma including a monomer γ shown in formula (14), 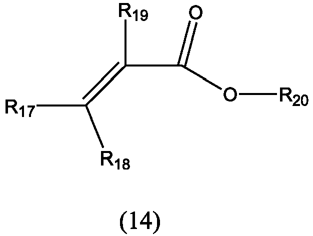 wherein, R₁₇, R₁₈ and R₁₉ are respectively and independently selected from a group consisting of: a hydrogen atom, a C₁-C₁₀ alkyl, and a halogen-substituted C₁-C₁₀ alkyl, and R₂₀ is a C₁-C₂₀ hydrocarbyl or a halogen-substituted C₁-C₂₀ hydrocarbyl. Further, for a better hydrophobicity, R₂₀ is a C₄-C₂₀ hydrocarbyl or a halogen-substituted C₄-C₂₀ hydrocarbyl. Considering the effect of halogen elements on the environment, according to some specific embodiments, R₁₇, R₁₈ and R₁₉ are respectively and independently selected from a group consisting of a hydrogen atom and a C₁-C₁₀ alkyl. Further, the R₁₇, R₁₈ and R₁₉ are respectively and independently selected from a group consisting of a hydrogen atom and a methyl, and R₂₀ is a C₁-C₂₀ hydrocarbyl, particularly the R₂₀ is a C₄-C₂₀ hydrocarbyl. According to some specific embodiments of the present disclosure, the hydrocarbyl is a saturated alkyl, such as a methyl, an ethyl, a propyl, a butyl, a pentyl, a hexyl or an octadecyl, etc. According to some specific embodiments of the present disclosure, the hydrocarbyl is an unsaturated alkenyl, alkynyl or aromatic hydrocarbyl. For example, the monomer γ can be one or more selected from a group consisting of a cyclohexyl methacrylate, an octadecyl acrylate, an isodecyl methacrylate, an allyl methacrylate, an isobornyl methacrylate, a tert-butyl methacrylate, a benzyl methacrylate, a phenyl methacrylate, an isopropyl methacrylate, and a 9-anthracene methyl methacrylate. According to some specific embodiments, the monomer γ has a structure shown in formula (15), 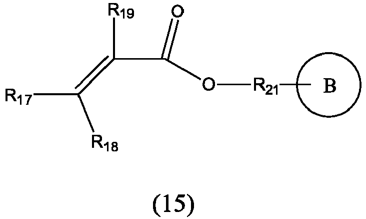 wherein, R₂₁ is a connecting bond, a C₁-C₁₀ alkylene, and a halogen-substituted C₁-C₁₀ alkylene, and B is an aromatic ring structure or a three to twenty-membered alicyclic structure. Further, B is a five-membered alicyclic structure or is a six-membered alicyclic structure. Further, B is a cyclohexyl or a cyclopentyl. Considering the effect of halogen elements on the environment, according to some specific embodiments, R₂₁ is a connecting bond or a C₁-C₁₀ alkylene, further, R₂₁ is a connecting bond, a methylene or an ethylidene. When the monomer γ has a structure shown in formula (15) and B is an alicyclic structure, the coating I and the coating II both have an alicyclic structure which has a better bonding effect. Therefore, the combination of the coating I and the coating II result in a better protective performance.

According to some specific embodiments of the present disclosure, the protective coating further includes a coating III. The coating III is a plasma polymerization coating formed by contacting the substrate with a plasma including a monomer δ. The coating II is a plasma polymerization coating formed on the coating III by contacting the coating III with a plasma including a monomer δ. The monomer δ includes a structural unit c and a structural unit d, and the structural unit c and the structural unit d both have a carbon-carbon double bond structure and an ester structure respectively. The coating III formed by plasma chemical vapor deposition of the monomer δ with double unsaturated ester structure is conducive to improving the adhesion between the substrate and coating II, thereby improving the density and adhesion of the protective coating. For example, the monomer δ may be one or more selected from a group consisting of a 1,4-butanediol methacrylate, a 1,6-hexanediol dimethacrylate, a ethylene glycol dimethacrylate, a diethylene glycol dimethacrylate, a triethylene glycol dimethacrylate, a tetraethylene glycol dimethacrylate, a 1,3-butanediol dimethacrylate, a neopentyl glycol dimethacrylate, a methacrylic anhydride, a 2-benzylidene malonic acid dipropyl-2-enyl ester, a diethyl diallyl malonate, a 1,4-butanediol diacrylate, a 1,4-butanediol dimethacrylate, and a 1,6-hexanediol diacrylate. According to some specific embodiments, the structural unit c has a structure shown in formula (16), 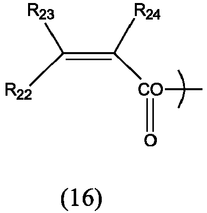 wherein, in some specific embodiments, R₂₂, R₂₃ and R₂₄ are respectively and independently selected from a halogen-substituted C₁-C₁₀ alkyl, further selected from a halogen-substituted C₁-C₄ alkyl. Considering the effect of halogen elements on the environment, in some specific embodiments, R₂₂, R₂₃ and R₂₄ are respectively and independently selected from a group consisting of a hydrogen atom and a C₁-C₁₀ alkyl, further selected from a group consisting of a hydrogen atom and a C₁-C₄ alkyl, and further selected from a group consisting of a hydrogen atom and a methyl. According to some specific embodiments, the structural unit d has a carbon-carbon double bond structure shown in formula (17), 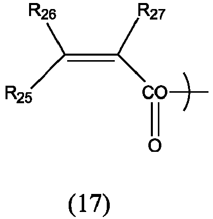 wherein, in some specific embodiments, R₂₅, R₂₆ and R₂₇ are respectively and independently selected from a halogen-substituted C₁-C₁₀ alkyl, further selected from a halogen-substituted C₁-C₄ alkyl. Considering the effect of halogen elements on the environment, in some specific embodiments, R₂₅, R₂₆ and R₂₇ are respectively and independently selected from a group consisting of a hydrogen atom and a C₁-C₁₀ alkyl, further selected from a group consisting of a hydrogen atom and a C₁-C₄ alkyl, and further selected from a group consisting of a hydrogen atom and a methyl. In some specific embodiments, the monomer δ has a structure shown in formula (18). 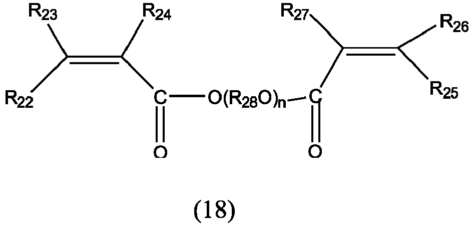 wherein, in some specific embodiments, R₂₈ is a halogen-substituted alkylene, and n is an integer ranging from 0 to 10. For example, n is an integer of 1, R₂₈ is a halogen-substituted C₂-C₁₀ alkylene such as a halogen-substituted ethylidene, a halogen-substituted propylidene, a halogen-substituted butylidene, a halogen-substituted pentylidene, etc. Considering the effect of halogen elements on the environment, in some specific embodiments, R₂₈ is a C₂-C₁₀ alkylene, and n is an integer ranging from 1 to 10. For example, n is an integer of 1, R₂₈ is a C₂-C₁₀ alkylene such as an ethylidene, a propylidene, a butylidene, a pentylidene, etc. For example, n is an integer ranging from 2 to 10, R₂₂ is an ethylidene or a propylidene and so on. The coating III, especially the coating III formed by the monomer δ including the diacrylate structure shown in formula (18), which is conducive to improving the adhesion between the substrate and coating II, thereby improving the density and adhesion of the protective coating.

In terms of plasma anti-corrosion coating, a common method is to use a perfluorinated monomer to plasma coat the substrate. For such coatings, there is a problem of poor adhesion to the substrate due to the perfluoro groups of the monomer, and fluoropolymers will release toxic substances such as perfluorooctyl carboxylate or perfluorooctane sulfonate to the environment, which will easily pollute the environment. In response, the United States Environmental Protection Agency (EPA) issued strict regulations to prohibit the use of fluoropolymers containing long carbon chains. The protective coating according to some specific embodiments of the present disclosure, on the one hand, has excellent adhesion force with the substrate, and on other hand, even without halogen F, has a better protective performance than the plasma coating formed by F-containing monomers.

Some specific embodiments of the present disclosure also provide a preparation method of the aforementioned protective coating. The method includes: providing a substrate, and forming the protective coating on the substrate by performing a plasma deposition. The plasmas and the substrate are described above.

According to some specific embodiments of the present disclosure, the specific conditions of the plasma coating can adopt the corresponding conditions in conventional technology. For example, the substrate is placed in a reaction chamber of a plasma chamber, the reaction chamber is vacuumized to 1mTorr to 250mTorr, and inert gases such as He, Ar, O₂ or mixed gases thereof are introduced. Monomers for reacting are introduced into the chamber in the form of vapor, and the flow rate of the monomers ranges from 40µL/min to 2000µL/min. The power supply is turned on to generate plasma, so that a chemical vapor deposition occurs on the surface of the substrate and the coating III, the coating II, the coating I are formed respectively. The temperature in the chamber is controlled in a range of 20°C to 80°C, the monomers are gasified at a temperature ranging from 70°C to 150°C and under vacuum condition. The plasmas are excited in a continuous wave, a plasma discharge power ranges from 10W to 180W, and a discharge duration time ranges from 100s to 7200s. Alternatively, the plasmas can be excited in a pulse mode, a pulse power ranges from 20W to 500W, a pulse frequency in the pulse mode ranges from 20Hz to 80KHz, a duty cycle ranges from 0.1% to 80%, and a discharge duration time ranges from 100s to 20000s.

The present disclosure is further described in the following specific embodiments.

### Embodiment

### Description of test method

5V salt water test: the test process was as follows: 1. 5V voltage was provided for circuit boards by a power supply; 2. the circuit boards were soaked in 3.6% salt water; 3. the current were detected by a computer; 4. the failure time (current > 0.6mA) was recorded.

Salt spray test: performing a test according to GB/T 2423.18-2000 environmental test method for electrical and electronic products.

High temperature and high humidity test: performing a test according to GB/T 2423.34-2012.

### Embodiment 1-1

(1) A substrate Fe sheet (30*20*2mm) and a substrate Mg sheet (30*20*2mm) were placed in a 500L plasma vacuum reaction chamber, the reaction chamber was vacuumized continuously to get the vacuum degree in the reaction chamber reach 80mTorr, and a temperature in the chamber was 35°C.
(2) Argon gas was introduced at a flow rate of 10sccm, and a radio frequency plasma discharge was turned on to pretreat the substrates. The discharge power in this pretreatment stage was 100W, and the discharge duration time was 80s.
(3) A mixture of a monomer of triethylene glycol dimethacrylate and a monomer of 3,4-epoxycyclohexylmethyl-3,4-epoxycyclohexyl formate (the mass ratio was 1:1) was introduced at a flow rate of 600µl/min, and the temperature in the chamber was 60°C. The plasmas in the chamber were generated by a radio frequency discharge, and the output mode was changed to pulse. The pulse width was 100µs, the pulse frequency was 100Hz, the discharge power was 10W, and the discharge duration time was 120min.
(4) After coating, air was introduced to restore the reaction chamber to normal pressure. The chamber was opened, and the Fe sheet and Mg sheet were taken out. A salt spray test and a high temperature and high humidity test were performed and the test results were listed in the following Table 1 and Table 2 respectively.

### Embodiment 1-2

(1) A substrate Fe sheet (30*20*2mm) and a substrate Mg sheet (30*20*2mm) were placed in a 500L plasma vacuum reaction chamber, the reaction chamber was vacuumized continuously to get the vacuum degree in the reaction chamber reach 20mTorr, and a temperature in the chamber was 45°C.
(2) Helium gas was introduced at a flow rate of 300sccm, and a radio frequency plasma discharge was turned on to pretreat the substrates. The discharge power in this pretreatment stage was 300W, and the discharge duration time was 60s.
(3) A mixture of a monomer of tetraethylene glycol dimethacrylate and a monomer of 3,4-epoxycyclohexylmethyl methacrylate (the mass ratio was 2:1) was introduced at a flow rate of 200µl/min, and the temperature in the chamber was 65°C. The plasmas in the chamber were generated by a radio frequency discharge, and the output mode was changed to pulse. The pulse width was 200µs, the pulse frequency was 100Hz, the discharge power was 35W, and the discharge duration time was 40min.
(4) After coating, air was introduced to restore the reaction chamber to normal pressure. The chamber was opened, and the Fe sheet and Mg sheet were taken out. A salt spray test and a high temperature and high humidity test were performed and the test results were listed in the following Table 1 and Table 2 respectively.

### Embodiment 1-3

(1) A substrate Fe sheet (30*20*2mm) and a substrate Mg sheet (30*20*2mm) were placed in a 500L plasma vacuum reaction chamber, the reaction chamber was vacuumized continuously to get the vacuum degree in the reaction chamber reach 250mTorr, and a temperature in the chamber was 45°C.
(2) Helium gas was introduced at a flow rate of 120sccm, and a radio frequency plasma discharge was turned on to pretreat the substrates. The discharge power in this pretreatment stage was 300W, and the discharge duration time was 90s.
(3) A mixture of a monomer of 1,6-hexanediol diacrylate and a monomer of 1,2-epoxy-4-vinyl cyclohexane (the mass ratio was 3:2) was introduced at a flow rate of 200µl/min, and the temperature in the chamber was 70°C. The plasmas in the chamber were generated by a radio frequency discharge, and the output mode was changed to pulse. The pulse width was 200µs, the pulse frequency was 50Hz, the discharge power was 100W, and the discharge duration time was 35min.
(4) After coating, air was introduced to restore the reaction chamber to normal pressure. The chamber was opened, and the Fe sheet and Mg sheet were taken out. A salt spray test and a high temperature and high humidity test were performed and the test results were listed in the following Table 1 and Table 2 respectively.

### Embodiment 1-4

(1) A substrate Fe sheet (30*20*2mm) and a substrate Mg sheet (30*20*2mm) were placed in a 500L plasma vacuum reaction chamber, the reaction chamber was vacuumized continuously to get the vacuum degree in the reaction chamber reach 100mTorr, and a temperature in the chamber was 80°C.
(2) Oxygen gas was introduced at a flow rate of 300sccm, and a microwave plasma discharge was turned on to pretreat the substrates. The discharge power in this pretreatment stage was 500W, and the discharge duration time was 90s.
(3) A mixture of a monomer of hydroxypropyl methacrylate and a monomer of bis ((3,4-epoxycyclohexyl) methyl) adipate (the mass ratio was 1:2) was introduced at a flow rate of 2000µl/min, and the temperature in the chamber was 45°C. The plasmas in the chamber were generated by a radio frequency discharge, and the output mode was changed to pulse. The pulse width was 300µs, the pulse frequency was 50Hz, the discharge power was 180W, and the discharge duration time was 15min.
(4) After coating, air was introduced to restore the reaction chamber to normal pressure. The chamber was opened, and the Fe sheet and Mg sheet were taken out. A salt spray test and a high temperature and high humidity test were performed and the test results were listed in the following Table 1 and Table 2 respectively.

### Embodiment 1-5

(1) A substrate Fe sheet (30*20*2mm) and a substrate Mg sheet (30*20*2mm) were placed in a 500L plasma vacuum reaction chamber, the reaction chamber was vacuumized continuously to get the vacuum degree in the reaction chamber reach 100mTorr, and a temperature in the chamber was 80°C.
(2) Helium gas was introduced at a flow rate of 180sccm, and a microwave plasma discharge was turned on to pretreat the substrates. The discharge power in this pretreatment stage was 120W, and the discharge duration time was 600s.
(3) A mixture of a monomer of 1,3-butanediol dimethacrylate and a monomer of vinyl cyclohexene diepoxide (the mass ratio was 2:1) was introduced at a flow rate of 800µl/min, and the temperature in the chamber was 45°C. The plasmas in the chamber were generated by a radio frequency discharge, and the output mode was changed to pulse. The pulse width was 300µs, the pulse frequency was 50Hz, the discharge power was 300W, and the discharge duration time was 20min.
(4) After coating, air was introduced to restore the reaction chamber to normal pressure. The chamber was opened, and the Fe sheet and Mg sheet were taken out. A salt spray test and a high temperature and high humidity test were performed and the test results were listed in the following Table 1 and Table 2 respectively.

### Embodiment 1-6

(1) A substrate Fe sheet (30*20*2mm) and a substrate Mg sheet (30*20*2mm) were placed in a 500L plasma vacuum reaction chamber, the reaction chamber was vacuumized continuously to get the vacuum degree in the reaction chamber reach 80mTorr, and a temperature in the chamber was 50°C.
(2) Helium gas was introduced at a flow rate of 160sccm, and a microwave plasma discharge was turned on to pretreat the substrates. The discharge power in this pretreatment stage was 180W, and the discharge duration time was 300s.
(3) A monomer of 1,2-epoxy-4-vinyl cyclohexane was introduced at a flow rate of 500µl/min, and the temperature in the chamber was 85°C. The plasmas in the chamber were generated by a radio frequency discharge, and the output mode was changed to pulse. The pulse width was 500µs, the pulse frequency was 20Hz, the discharge power was 100W, and the discharge duration time was 20min.
(4) After coating, air was introduced to restore the reaction chamber to normal pressure. The chamber was opened, and the Fe sheet and Mg sheet were taken out. A salt spray test and a high temperature and high humidity test were performed and the test results were listed in the following Table 1 and Table 2 respectively.

### Comparative Embodiment 1-1

(1) A substrate Fe sheet (30*20*2mm) and a substrate Mg sheet (30*20*2mm) were placed in a 500L plasma vacuum reaction chamber, the reaction chamber was vacuumized continuously to get the vacuum degree in the reaction chamber reach 80mTorr, and a temperature in the chamber was 60°C.
(2) Helium gas was introduced at a flow rate of 140sccm, and a microwave plasma discharge was turned on to pretreat the substrates. The discharge power in this pretreatment stage was 180W, and the discharge duration time was 200s.
(3) A monomer of ethylene glycol dimethacrylate was introduced at a flow rate of 700µl/min, and the temperature in the chamber was 55°C. The plasmas in the chamber were generated by a radio frequency discharge, and the output mode was changed to pulse. The pulse width was 300µs, the pulse frequency was 50Hz, the discharge power was 80W, and the discharge duration time was 40min.
(4) After coating, air was introduced to restore the reaction chamber to normal pressure. The chamber was opened, and the Fe sheet and Mg sheet were taken out. A salt spray test and a high temperature and high humidity test were performed and the test results were listed in the following Table 1 and Table 2 respectively.

**Table 1 Salt Spray Test Results of Embodiment 1-1 to Embodiment 1-6 and Comparative Embodiment 1-1**

| Coating Salt Spray Test (5% NaCl solution) | | | |
|---|---|---|---|
| | Thickness of Coating (nm) | Fe sheet | Mg sheet |
| Embodiment 1-1 | 500 | >100h | >50h |
| Embodiment 1-2 | | >180h | >60h |
| Embodiment 1-3 | | >180h | >60h |
| Embodiment 1-4 | | 156h | >60h |
| Embodiment 1-5 | | >180h | >60h |
| Embodiment 1-6 | | >80h | >30h |
| Comparative Embodiment 1-1 | | >60h | >24h |

**Table 2 High Temperature and High Humidity Test Results of Embodiment 1-1 to Embodiment 1-6 and Comparative Embodiment 1-1**

| High Temperature and High Humidity Test (Temperature 60°C, Humidity 90%rh ) | | | |
|---|---|---|---|
| | Thickness of Coating (nm) | Fe sheet | Mg sheet |
| Embodiment 1-1 | 500 | 150h | >72h |
| Embodiment 1-2 | | >250h | >72h |
| Embodiment 1-3 | | >250h | >72h |
| Embodiment 1-4 | | >250h | >72h |
| Embodiment 1-5 | | >250h | >72h |
| Embodiment 1-6 | | 120h | >48h |
| Comparative Embodiment 1-1 | | 80h | >36h |

### Embodiment 2-1

A circuit board, a Mg sheet and a Fe sheet were placed in a plasma chamber, the chamber was vacuumized continuously to 20mTorr, and helium gas was introduced at a flow rate of 80sccm. A radio frequency plasma discharge was turned on to pretreat the substrates, the discharge power in this pretreatment stage was 100W, and the discharge duration time was 600s.

Thereafter, a monomer of 1,4-butylene dimethacrylate was gasified at a gasification temperature of 100°C and then was introduced into the chamber for plasma chemical vapor deposition, and the flow rate of the monomer was 150µL/min. The plasmas in the chamber were generated by a radio frequency discharge, and the output mode was pulse. The pulse duty cycle was 25%, the pulse frequency was 1000Hz, the discharge power was 50W, and the discharge duration time was 3600s.

Thereafter, a mixture of a monomer of 1,6-hexanediol diacrylate and a monomer of 1,2-epoxy-4-vinyl cyclohexane (the mass ratio was 2:1) was introduced at a flow rate of 40µl/min, and the gasification temperature of the monomers was 120°C. The plasma in the chamber was generated by a radio frequency discharge, and the output mode was pulse. The pulse duty cycle was 25%, the pulse frequency was 1000Hz, the discharge power was 10W, and the discharge duration time was 7200s.

Thereafter, a monomer vapor of octadecyl acrylate was introduced at a flow rate of 100µl/min, and the gasification temperature of the monomer was 120°C. The plasmas in the chamber were generated by a radio frequency discharge, and the output mode was pulse. The pulse duty cycle was 25%, the pulse frequency was 1000Hz, the discharge power was 180W, and the discharge duration time was 7200s. The coating process had been accomplished.

After coating, the compressed air was introduced to restore the reaction chamber to normal pressure. The circuit board, the Mg sheet and the Fe sheet were taken out. A salt water test and a salt spray test were performed and the test results were listed in the Table 3.

### Embodiment 2-2

A circuit board, a Mg sheet and a Fe sheet were placed in a plasma chamber, the chamber was vacuumized continuously to 8mTorr, and helium gas was introduced at a flow rate of 80sccm. A radio frequency plasma discharge was turned on to pretreat the substrates, the discharge power in this pretreatment stage was 100W, and the discharge duration time was 600s.

Thereafter, a monomer of 1,6-hexanediol dimethacrylate was gasified at a gasification temperature of 100°C and then was introduced into the chamber for plasma chemical vapor deposition, and the flow rate of the monomer was 150µL/min. The plasmas in the chamber were generated by a radio frequency discharge, and the output mode was pulse. The pulse duty cycle was 45%, the pulse frequency was 500Hz, the discharge power was 50W, and the discharge duration time was 3600s.

Thereafter, a mixture of a monomer of 1,6-hexanediol dimethacrylate and a monomer of vinyl cyclohexene diepoxide (the mass ratio was 1:2) was introduced at a flow rate of 40µl/min, and the gasification temperature of the monomers was 120°C. The plasmas in the chamber were generated by a radio frequency discharge, and the output mode was pulse. The pulse duty cycle was 45%, the pulse frequency was 500Hz, the discharge power was 10W, and the discharge duration time was 7200s.

Thereafter, a monomer vapor of tert-butyl methacrylate was introduced at a flow rate of 100µl/min, and the gasification temperature of the monomer was 120°C. The plasmas in the chamber were generated by a radio frequency discharge, and the output mode was pulse. The pulse duty cycle was 45%, the pulse frequency was 500Hz, the discharge power was 25W, and the discharge duration time was 7200s. The coating process had been accomplished.

After coating, the compressed air was introduced to restore the reaction chamber to normal pressure. The circuit board, the Mg sheet and the Fe sheet were taken out. A salt water test and a salt spray test were performed and the test results were listed in the Table 3.

### Embodiment 2-3

A circuit board, a Mg sheet and a Fe sheet were placed in a plasma chamber, the chamber was vacuumized continuously to 100mTorr, and helium gas was introduced at a flow rate of 120sccm. A radio frequency plasma discharge was turned on to pretreat the substrates, the discharge power in this pretreatment stage was 180W, and the discharge duration time was 300s.

Thereafter, a monomer of 1,6-hexanediol dimethacrylate was gasified at a gasification temperature of 110°C and then was introduced into the chamber for plasma chemical vapor deposition, and the flow rate of the monomer was 220µL/min. The plasmas in the chamber were generated by a radio frequency discharge, and the output mode was pulse. The pulse duty cycle was 45%, the pulse frequency was 5000Hz, the discharge power was 25W, and the discharge duration time was 2200s.

Thereafter, a mixture of a monomer of triethylene glycol dimethacrylate and a monomer of 3,4-epoxycyclohexylmethyl methacrylate (the mass ratio was 3:2) was introduced at a flow rate of 40µl/min, and the gasification temperature of the monomers was 120°C. The plasmas in the chamber were generated by a radio frequency discharge, and the output mode was pulse. The pulse duty cycle was 45%, the pulse frequency was 5000Hz, the discharge power was 10W, and the discharge duration time was 7200s.

Thereafter, a monomer vapor of isobornyl methacrylate was introduced at a flow rate of 100µl/min, and the gasification temperature of the monomer was 120°C. The plasmas in the chamber were generated by a radio frequency discharge, and the output mode was pulse. The pulse duty cycle was 45%, the pulse frequency was 5000Hz, the discharge power was 25W, and the discharge duration time was 7200s. The coating process had been accomplished.

After coating, the compressed air was introduced to restore the reaction chamber to normal pressure. The circuit board, the Mg sheet and the Fe sheet were taken out. A salt water test and a salt spray test were performed and the test results were listed in the Table 3.

### Embodiment 2-4

A circuit board and a Mg sheet were placed in a plasma chamber, the chamber was vacuumized continuously to 80mTorr, and helium gas was introduced at a flow rate of 120sccm. A radio frequency plasma discharge was turned on to pretreat the substrates, the discharge power in this pretreatment stage was 180W, and the discharge duration time was 300s.

Thereafter, a monomer of 1,4-butanediol dimethacrylate was gasified at a gasification temperature of 110°C and then was introduced into the chamber for plasma chemical vapor deposition, and the flow rate of the monomer was 120µL/min. The plasmas in the chamber were generated by a radio frequency discharge, and the output mode was pulse. The pulse duty cycle was 25%, the pulse frequency was 20kHz, the discharge power was 20W, and the discharge duration time was 3600s.

Thereafter, a mixture of a monomer of 1,6-hexanediol dimethacrylate and a monomer of bis ((3,4-epoxycyclohexyl) methyl) adipate (the mass ratio was 2:1) was introduced at a flow rate of 150µl/min, and the gasification temperature of the monomers was 120°C. The plasmas in the chamber were generated by a radio frequency discharge, and the output mode was pulse. The pulse duty cycle was 25%, the pulse frequency was 20kHz, the discharge power was 10W, and the discharge duration time was 3600s.

Thereafter, a monomer vapor of benzyl methacrylate was introduced at a flow rate of 150µl/min, and the gasification temperature of the monomer was 150°C. The plasmas in the chamber were generated by a radio frequency discharge, and the output mode was pulse. The pulse duty cycle was 25%, the pulse frequency was 20kHz, the discharge power was 150W, and the discharge duration time was 7200s. The coating process had been accomplished.

After coating, the compressed air was introduced to restore the reaction chamber to normal pressure. The circuit board, the Mg sheet and the Fe sheet were taken out. A salt water test and a salt spray test were performed and the test results were listed in the Table 3.

### Comparative Embodiment 2-1

A circuit board, a Mg sheet and a Fe sheet were placed in a plasma chamber, the chamber was vacuumized continuously to 80mTorr, and helium gas was introduced at a flow rate of 120sccm. A radio frequency plasma discharge was turned on to pretreat the substrates, the discharge power in this pretreatment stage was 180W, and the discharge duration time was 300s.

Thereafter, a monomer of 1,4-butanediol diacrylate was gasified at a gasification temperature of 110°C and then was introduced into the chamber for plasma chemical vapor deposition, and the flow rate of the monomer was 120µL/min. The plasmas in the chamber were generated by a radio frequency discharge, and the output mode was pulse. The pulse duty cycle was 25%, the pulse frequency was 20kHz, the discharge power was 20W, and the discharge duration time was 3600s.

Thereafter, a monomer of 2-(perfluorohexyl)ethyl methacrylate was introduced at a flow rate of 120µl/min, and the gasification temperature of the monomer was 110°C. The plasmas in the chamber were generated by a radio frequency discharge, and the output mode was pulse. The pulse duty cycle was 25%, the pulse frequency was 20kHz, the discharge duration time was 3600s, and the discharge power was 180W.

Thereafter, a monomer vapor of 2-(perfluorododecyl)ethylacrylate was introduced at a flow rate of 160µl/min, and the gasification temperature of the monomer was 110°C. The plasmas in the chamber were generated by a radio frequency discharge, and the output mode was pulse. The pulse duty cycle was 25%, the pulse frequency was 20kHz, the discharge duration time was 7200s, and the discharge power was 180W. The coating process had been accomplished.

After coating, the compressed air was introduced to restore the reaction chamber to normal pressure. The circuit board, the Mg sheet and the Fe sheet were taken out. A salt water test and a salt spray test were performed and the test results were listed in the Table 3.

**Table 3 Performance Test Results of Embodiment 2-1 to Embodiment 2-4 and Comparative Embodiment 2-1**

| Coating Performance Test | | | | | | | | | |
|---|---|---|---|---|---|---|---|---|---|
| Embodi ment / Compara tive Embodi ment | 5V Salt Water Test | | | 5V Salt Spray Test (5% NaCl solution) | | | | | |
| | substrate | thickness (nm) | time | substrate | thickness (nm) | time | substrate | thickness (nm) | time |
| Embodi ment 2-1 | circuit board | 357 | 9h52min | Fe | 352 | 196h | Mg | 357 | 116h |
| Embodi ment 2-2 | circuit board | 385 | 11h15min | Fe | 375 | 220h | Mg | 385 | 110h |
| Embodi ment 2-3 | circuit board | 371 | 13h8min | Fe | 356 | 250h | Mg | 366 | 130h |
| Embodi ment 2-4 | circuit board | 373 | 10h40min | Fe | 387 | 234h | Mg | 377 | 120h |
| Compara tive Embodi ment 2-1 | circuit board | 364 | 5h20min | Fe | 365 | 150h | Mg | 355 | 80h |

The results in above table 3 show that even without halogen F, the protective coating of the present disclosure has a better protective performance than the plasma coating formed by perfluorinated monomers.

Although the present disclosure has been disclosed above, the disclosure is not limited hereto. Those skilled in the art can modify and vary the embodiments without departing from the spirit and scope of the present disclosure. Therefore, the scope of protection of the present disclosure shall be subject to the scope defined in claims.

## Claims

1. A protective coating II, which is a plasma polymerization coating formed on a surface of a substrate by contacting plasmas, wherein the plasmas comprise a plasma of a monomer α, and the monomer α comprises an alicyclic epoxy structural unit shown in formula (1), 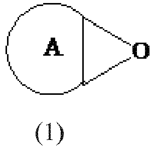 wherein A is a three to twenty-membered alicyclic structure.

2. The protective coating II according to claim 1, wherein A is a five-membered alicyclic structure or a six-membered alicyclic structure.

3. The protective coating II according to claim 1, wherein the monomer α further comprises at least one selected from a group consisting of: a carbon-carbon double bond structural unit, a carbon-carbon triple bond structural unit, and an epoxy structural unit.

4. The protective coating II according to claim 3, wherein the monomer α has a structure shown in formula (2), 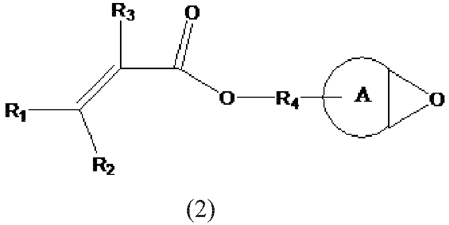
wherein R₁, R₂ and R₃ are respectively and independently selected from a group consisting of: a hydrogen atom, a C₁-C₁₀ alkyl, and a halogen-substituted C₁-C₁₀ alkyl; and
R₄ is a connecting bond, a C₁-C₁₀ alkylene or a halogen-substituted C₁-C₁₀ alkylene.

5. The protective coating II according to claim 4, wherein the R₁, R₂ and R₃ are respectively and independently selected from a group consisting of a hydrogen atom and a methyl; and R₄ is a connecting bond, a methylene or an ethylidene.

6. The protective coating II according to claim 5, wherein the monomer α has a structure shown in formula (3) or a structure shown in formula (4),

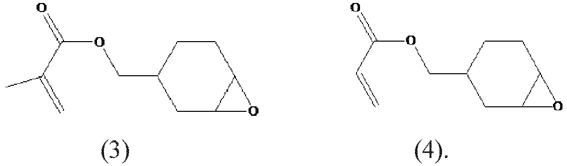

7. The protective coating II according to claim 3, wherein the monomer α has a structure shown in formula (5), 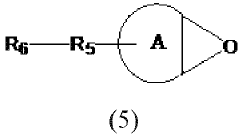
wherein R₅ is a connecting bond, a C₁-C₁₀ alkylene or a halogen-substituted C₁-C₁₀ alkylene; and
R₆ has a structure selected from a group consisting of: 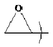 or 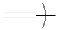 .

8. The protective coating II according to claim 7, wherein the monomer α has a structure shown in formula (6) or a structure shown in formula (7),

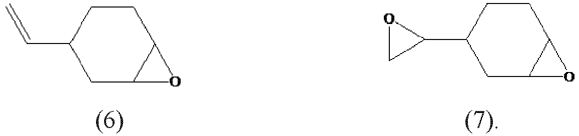

9. The protective coating II according to claim 3, wherein the monomer α has a structure shown in formula (8), 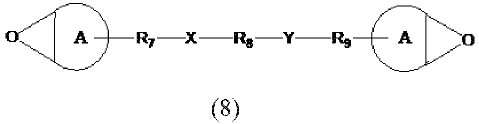
wherein, R₇ and R₉ are respectively and independently selected from a group consisting of: a connecting bond, a C₁-C₁₀ alkylene, and a halogen-substituted C₁-C₁₀ alkylene;
R₈ is a C₁-C₁₀ alkylene or a halogen-substituted C₁-C₁₀ alkylene; and
X and Y are respectively and independently selected from a group consisting of: a connecting bond, an oxygen atom, a carbonyl, and an ester.

10. The protective coating II according to claim 9, wherein the monomer α has a structure shown in formula (9) or a structure shown in formula (10),

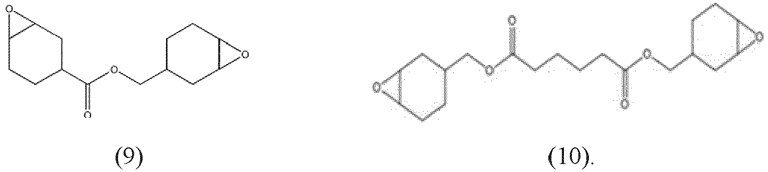

11. The protective coating II according to claim 1, wherein the plasmas also comprise a plasma of a monomer β, the monomer β comprises a structural unit a, and the structural unit a has a structure shown in formula (11); 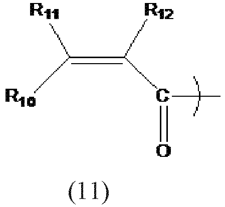 wherein R₁₀, Rn and R₁₂ are respectively and independently selected from a group consisting of: a hydrogen atom, a C₁-C₁₀ alkyl, and a halogen-substituted C₁-C₁₀ alkyl.

12. The protective coating II according to claim 11, wherein the monomer β also comprises a structural unit b, and the structural unit b comprises at least one selected from a group consisting of: a double bond structural unit, a triple bond structural unit, and an epoxy structural unit.

13. The protective coating II according to claim 12, wherein the structural unit b has a structure shown in formula (12), 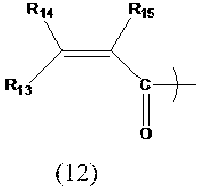 wherein, R₁₃, R₁₄ and R₁₅ are respectively and independently selected from a group consisting of: a hydrogen atom, a C₁-C₁₀ alkyl, and a halogen-substituted C₁-C₁₀ alkyl.

14. The protective coating II according to claim 13, wherein the monomer β has a structure shown in formula (13), 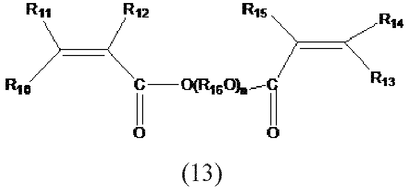 wherein, R₁₆ is a C₂-C₁₀ alkylene or a halogen-substituted C₂-C₁₀ alkylene, and n is an integer ranging from 1 to 10.

15. The protective coating II according to claim 14, wherein the R₁₀, R₁₁, R₁₂, R₁₃, R₁₄ and R₁₅ are respectively and independently selected from a group consisting of a hydrogen atom and a methyl.

16. The protective coating II according to claim 1, wherein the substrate is selected from metal, plastic, fabric, glass, electrical assemblies, optical instruments or electrical components.

17. A preparation method of the protective coating II as claimed in any one of claims from claim 1 to claim 16, comprising:
providing a substrate; and
contacting the substrate with plasmas to form a plasma polymerization coating on a surface of the substrate.

18. The preparation method according to claim 17, wherein the plasmas are excited in a pulse manner.

19. The preparation method according to claim 18, wherein a pulse frequency of the pulse manner ranges from 20Hz to 80kHz, a pulse duty cycle ranges from 0.1% to 80%, and an average pulse power density ranges from 0.001W/m³ to 500W/m³.

20. A device, wherein the device comprises the protective coating II claimed in any one of claims from claim 1 to claim 16 on at least part of the surface thereof.

21. A protective coating, comprising a coating I and a coating II deposited on a substrate, wherein
the coating II is the protective coating II claimed in any one of claims from claim 1 to claim 16;
the coating I is a plasma polymerization coating formed on the coating II by contacting the coating II with a plasma comprising a monomer γ; and
the monomer γ comprises one or more selected from a group consisting of: an alkane, a halogenated alkane, an alkene, a halogenated alkene, an alkyne, a halogenated alkyne, an acrylic ester, and a halogenated acrylic ester.

22. The protective coating according to claim 21, wherein the monomer γ has a structure shown in formula (14), 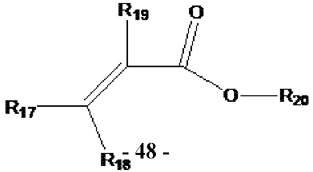 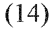
wherein, R₁₇, R₁₈ and R₁₉ are respectively and independently selected from a group consisting of: a hydrogen atom, a C₁-C₁₀ alkyl, and a halogen-substituted C₁-C₁₀ alkyl; and
R₂₀ is a C₁-C₂₀ hydrocarbyl or a halogen-substituted C₁-C₂₀ hydrocarbyl.

23. The protective coating according to claim 22, wherein R₁₇, R₁₈ and R₁₉ are respectively and independently selected from a group consisting of a hydrogen atom and a methyl; and
R₂₀ is a C₄-C₂₀ hydrocarbyl or a halogen-substituted C₄-C₂₀ hydrocarbyl.

24. The protective coating according to claim 22, wherein the monomer γ has a structure shown in formula (15), 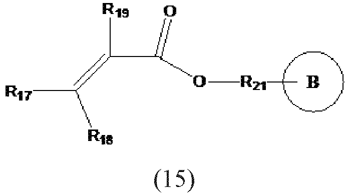
wherein R₂₁ is a connecting bond, a C₁-C₁₀ alkylene, and a halogen-substituted C₁-C₁₀ alkylene; and
B is an aromatic ring structure or a three to twenty-membered alicyclic structure.

25. The protective coating according to claim 24, wherein R₂₁ is a connecting bond, a methylene or an ethylidene, and B is a cyclohexyl or a cyclopentyl.

26. The protective coating according to claim 21, further comprising a coating III, wherein the coating III is a plasma polymerization coating formed by contacting the substrate with a plasma comprising a monomer δ;
the coating II is a plasma polymerization coating formed on the coating III by contacting the coating III with a plasma comprising a monomer δ; and
the monomer δ comprises a structural unit c and a structural unit d, and the structural unit c and the structural unit d both have a carbon-carbon double bond structure and an ester structure respectively.

27. The protective coating according to claim 26, wherein the structural unit c has a structure shown in formula (16), 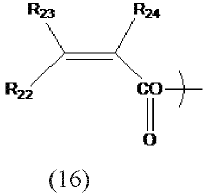 wherein R₂₂, R₂₃ and R₂₄ are respectively and independently selected from a group consisting of: a hydrogen atom, a C₁-C₁₀ alkyl, and a halogen-substituted C₁-C₁₀ alkyl.

28. The protective coating according to claim 26, wherein the structural unit d has a structure shown in formula (17), 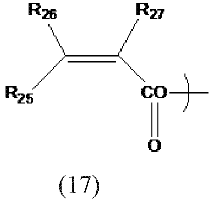 wherein R₂₅, R₂₆ and R₂₇ are respectively and independently selected from a group consisting of: a hydrogen atom, a C₁-C₁₀ alkyl, and a halogen-substituted C₁-C₁₀ alkyl.

29. The protective coating according to claim 26, wherein the monomer δ has a structure shown in formula (18), 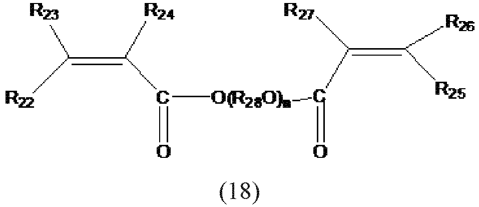 wherein R₂₈ is a C₂-C₁₀ alkylene or a halogen-substituted C₂-C₁₀ alkylene, n is an integer ranging from 0 to 10, and R₂₂, R₂₃, R₂₄, R₂₅, R₂₆ and R₂₇ are respectively and independently selected from a group consisting of a hydrogen atom, a C₁-C₁₀ alkyl, and a halogen-substituted C₁-C₁₀ alkyl.

30. The protective coating according to claim 29, wherein the R₂₂, R₂₃, R₂₄, R₂₅, R₂₆ and R₂₇ are respectively and independently selected from a group consisting of a hydrogen atom and a methyl.

31. A preparation method of the protective coating as claimed in any one of claims from claim 21 to claim 30, comprising:
providing a substrate; and
forming the protective coating on the substrate by performing a plasma deposition.

32. The preparation method according to claim 31, wherein the plasma is a pulse plasma.

33. The preparation method according to claim 32, wherein the pulse plasma is generated by applying a pulse voltage discharge, wherein, a pulse power ranges from 20W to 500W, a pulse frequency ranges from 20Hz to 80kHz, a pulse duty cycle ranges from 0.1% to 80%, and a plasma discharge duration time ranges from 100s to 20000s.

34. A device, wherein the device comprises the protective coating claimed in any one of claims from claim 21 to claim 30 on at least part of the surface thereof.
